# EUROPEAN PATENT APPLICATION

(11) **EP 3 038 262 A1**
(43) Date of publication of application: **29.06.2016**
(21) Application number: 15199965.3
(22) Date of filing: 14.12.2015
(51) Int. Cl.: H04B 1/04

(54) **SYSTEMS AND METHODS FOR EFFICIENT MULTI-CHANNEL SATCOM WITH DYNAMIC POWER SUPPLY AND DIGITAL PRE-DISTORTION**

(30) Priority: 23.12.2014 US 201414580858
(71) Applicant: Honeywell International Inc., Morris Plains, NJ 07950 (US)
(72) Inventor: BODDUPALLY, AnjayaChary, Morris Plains, NJ 07950 (US); MALAGA, Alfonso, Morris Plains, NJ 07950 (US); RANA, Narayan Singh, Morris Plains, NJ 07950 (US)
(74) Representative: Houghton, Mark Phillip

(57) **Abstract**

A radio system, comprising an antenna; a baseband module, a power amplifier; and a variable power supply. The baseband module is configured to output a first signal to the antenna, pre-distort the first signal based on computed coefficients, and output a second signal. The second signal is determined based on one or more characteristics of the first signal, and the second signal is output if there is a change in the one or more characteristics of the first signal. The power amplifier is communicatively coupled to the baseband module and the antenna, and is configured to amplify the pre-distorted signal. The variable power supply is communicatively coupled to the power amplifier and the baseband module. The variable power supply is configured to receive the second signal and generate a variable drain supply voltage corresponding to the second signal. The drain supply voltage is output to the power amplifier.

## Description

### BACKGROUND

A multi-channel SATCOM is an avionics communication system which provides voice and/or data communications worldwide carrying high peak to average power ratio(PAPR) modulation schemes that provide high spectral efficiency. The multi-channel SATCOM is configured to provide single to several independent simultaneous channels for communication. The number of channels at any given time is based on the number of simultaneous voice and/or data users requiring service.

### SUMMARY

In one embodiment, a radio system is provided. The radio system comprises an antenna; a baseband module, a power amplifier; and a variable power supply. The baseband module is configured to output a first signal to the antenna, pre-distort the first signal based on computed coefficients, and output a second signal. The second signal is determined based on one or more characteristics of the first signal, and the second signal is output if there is a change in the one or more characteristics of the first signal. The power amplifier is communicatively coupled to the baseband module and the antenna, and is configured to amplify the pre-distorted signal. The variable power supply is communicatively coupled to the power amplifier and the baseband module. The variable power supply is configured to receive the second signal and generate a variable drain supply voltage corresponding to the second signal. The drain supply voltage is output to the power amplifier.

### DRAWINGS

Understanding that the drawings depict only exemplary embodiments and are not therefore to be considered limiting in scope, the exemplary embodiments will be described with additional specificity and detail through the use of the accompanying drawings, in which:
Figure 1 is a block diagram illustrating a radio system of one embodiment of the present disclosure.
Figure 2 is a block diagram illustrating a baseband module and its connections according to one embodiment of the present disclosure.
Figure 3 is an exemplary graph showing efficiency vs. output power for different drain supply voltages provided to a power amplifier of one embodiment of the present disclosure.
Figure 4 is a flow chart illustrating a method of increasing the efficiency of a radio system according to one embodiment of the present disclosure.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

Modem multi-channel radios (e.g., SATCOM) are required to transmit waveforms with high output power. The wave forms do not have a constant envelope (amplitude) and can have large variations in amplitude where the ratio of the highest amplitude to the average amplitude can exceed ten decibels (dB). The average output power of the high power amplifierof the radio must be backed-off relative to the maximum output power of the high power amplifier by at least an amount equal to the peak to average power ratio(PAPR) of the waveform. This means a large amount of power must be provided to the high power amplifier to satisfy the highest output power requirements. For example, a system requiring a PAPR of 10dB with an average output power of thirty watts (W) would require the high power amplifier to be capable of outputting 300W.When the modulation employed by the system is non-constant envelope, the power amplifier shouldalso be linear over the entire range of amplitudes so as not to distort the waveform because the spectral emissions mask requirements cannot be met if there is distortion.

Most of the power consumption for a multi-channel SATCOM radio is by its high power amplifier. A high power amplifier is most efficient when operating closer to its saturation level. The saturation level for a high power amplifier is where the amplifier can no longer maintain a fixed signal gain and becomes non-linear. Therefore when the modulation is non constant envelope it is desirable to set the operating average output power of the amplifier as close as possible to saturation but not so close that any variations in the amplitude of the RF waveform get clipped (distorted) by the non-linear behavior of the amplifier near its saturation level. Traditional high power amplifiers of multi-channel radios operate with a fixed supply voltage. The efficiency of a high power amplifier is the ratio of the average RF output power over the amount of DC power supplied to the electronics. DC Powerthat is supplied to the electronics but not used is dissipated as heat. For SATCOM applications where the satellite is geostationary at near constant distance from mobile users on or near the surface of the Earth, the desired average RF output power is directly proportional to the number of carriers and the minimum amount of back-off from saturation that the power amplifier needs to be operated at is equal to the PAPR of the waveform when operating with the maximum number of carriers. Therefore, the fewer the number of carriers, the more inefficient the amplifier and the more DC supply power that is dissipated as heat. Furthermore, when the power amplifier is designed to operate with a large number of carriers and then it is operated with fewer carriers, the average RF output power is reduced proportionally to the reduction in the number of carriers, resulting in increased back-off from saturation, and thus an even more inefficient use of the DC power supplied to the power amplifier.

Traditional high power amplifiers of multi-channel radios operate with a fixed supply voltage. High power amplifiers with fixed supply voltages are inefficient when delivering low output power as the ratio of power used to that supplied decreases. Inefficient high power amplifiers produce large amounts of heat and require more expensive and/or bulky and heavy cooling systems for the electronics. There is a need in the art for a system that provides an RFhigh power amplifier that makes more efficient use of the DC power supplied to it to generate the RF output.

The embodiments described below provide systems and methods for operating a multi-channel radio with high efficiency. The embodiments described below vary the drain supply voltage to the high power amplifierwhen there is a change in the number of carriers or the modulation scheme in order to increase the efficiency of the high power amplifier even when the number of carriers is reduced. The embodiments described below also include applying digital pre-distortion to the modulated signal before transmission in order to compensate for the non-linear behavior of the power amplifier when the waveform peaks are close to the compression point of the amplifier and thus allow operation closer to compression where the power amplifier is more efficient.

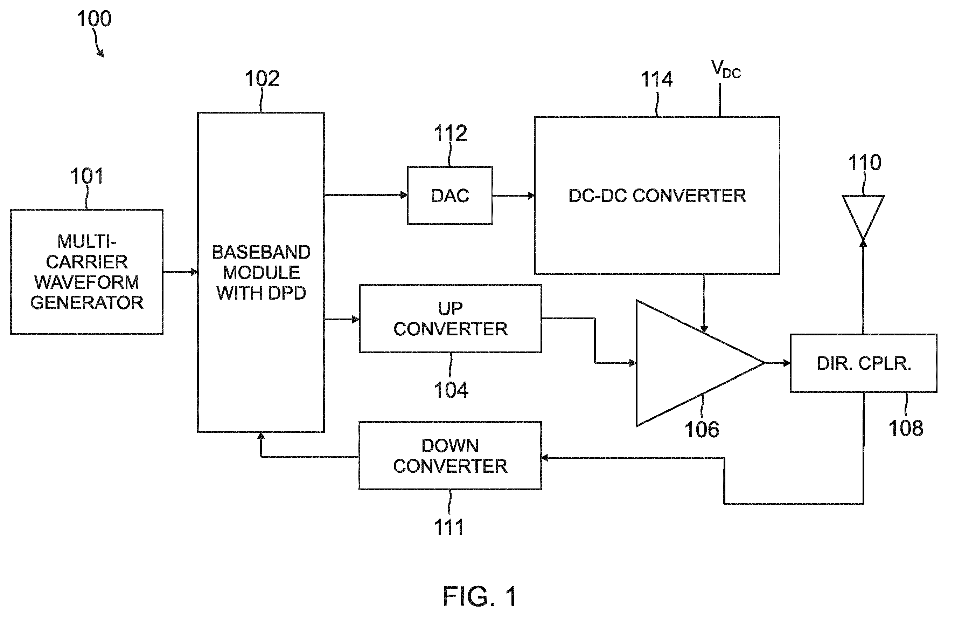

Figure 1 is a block diagram of one embodiment of an exemplary radio system 100. In exemplary embodiments, the radio system 100 is implemented as, but not limited to, a satellite communications (SATCOM) radio, an ultra-high frequency (UHF) radio, or a very high frequency (VHF) radio. As shown in Figure 1, the radio system 100 includes a multi-carrier waveform generator 101, a baseband module 102, a radio frequency (RF) up converter 104, a high power amplifier 106, a directional coupler 108, an antenna 110, a RF down converter 111, a digital-to-analog converter (DAC) 112, and a DC-to-DC(DC-DC) converter 114. Figure 1 only includes the transmitter functions of the radio system. It is to be understood that this is for simplicity of the figure and that the radio system 100 is also configured to receive transmissions.

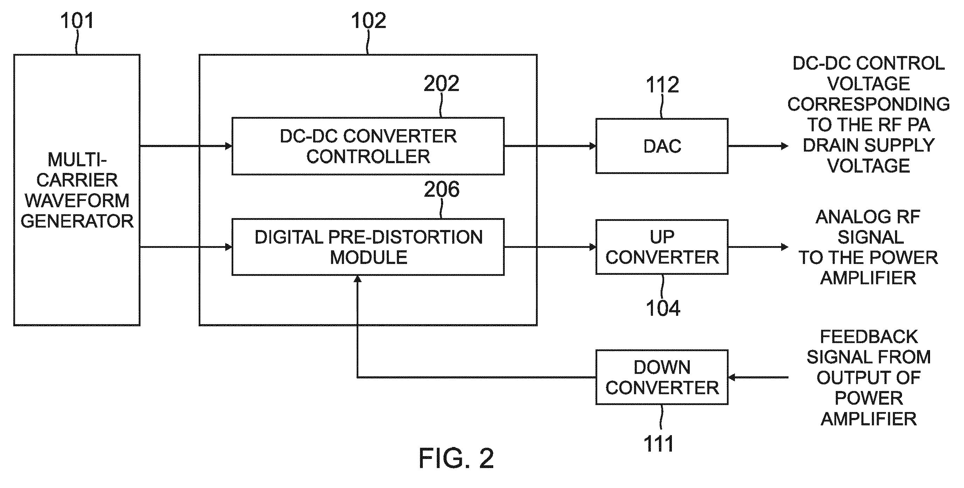

Figure 2 illustrates an example baseband module 102 and its connections according to one embodiment of the present disclosure. The baseband module 102 includes a DC-DC converter controller 202 and a digital pre-distortion module 206. In some exemplary embodiments, the DC-DC converter controller 202 and the digital pre-distortion module206 are implemented using computer executable instructions executed by a processing device. In other exemplary embodiments, the DC-DC converter controller 202 and the digital pre-distortion module 206 can be implemented in digital hardware or programmable hardware (*e.g*., field programmable gate array). In some exemplary embodiments, the DC-DC converter controller 202 and the digital pre-distortion module 206 are the same module.

In exemplary embodiments, the baseband module 102includes or functions with software programs, firmware or other computer readable instructions for carrying out various methods, process tasks, calculations, and control functions described herein. These instructions are typically stored on any appropriate computer readable medium used for storage of computer readable instructions or data structures. The computer readable medium, can be implemented as any available media that can be accessed by a general purpose or special purpose computer or processor, or any programmable logic device. Suitable processor-readable media may include storage or memory media such as magnetic or optical media. For example, storage or memory media may include conventional hard disks, Compact Disk - Read Only Memory (CD-ROM), volatile or non-volatile media such as Random Access Memory (RAM) (including, but not limited to, Synchronous Dynamic Random Access Memory (SDRAM), Double Data Rate (DDR) RAM, RAMBUS Dynamic RAM (RDRAM), Static RAM (SRAM), etc.), Read Only Memory (ROM), Electrically Erasable Programmable ROM (EEPROM), and flash memory, etc. Suitable processor-readable media may also include transmission media such as electrical, electromagnetic, or digital signals, conveyed via a communication medium such as a network and/or a wireless link.

The baseband module 102 is configured to receive multiple carrier signals for communication from the multi-carrier waveform generator 101. The baseband module 102 receives a generated multi-carrier signal from the multi-carrier waveform generator 101 and generates a first digital signal to be sent along a first communication path to the antenna 110 for broadcast. The baseband module 102 performs the modulations of each carrier. In exemplary embodiments, the baseband module 102 is configured to modulate the received signals using techniques known to one of skill in the art.

In exemplary embodiments, the baseband module 102 includes a digital-to-analog converter (DAC) to convert the modulated first digital signal to a first analog signal. In other exemplary embodiments, the DAC is included in the RF up converter 104, which is communicatively coupled to the baseband module 102. In exemplary embodiments, the first analog signal is up-converted from a baseband or intermediate frequency to a radio frequency in the RF up converter 104. The first analog signal is then radiated via the antenna 106.

The baseband module 102 also includes the digital pre-distortion module 206 to ensure that spectral emissions mask requirements can be met. Digital pre-distortion is a linearization technique that compensates for the non-linear behavior of the high power amplifier 106. The digital pre-distortion module 206 uses computed coefficients when it applies a mathematical function, such as a polynomial function, to the modulated signal in a manner opposite to the distortion introduced by the high power amplifier 106. In some exemplary embodiments, the digital pre-distortion module generates new/updated coefficients after a set period, which can be, but is not limited to, once per second, once per minute, once per hour, etc.

To generate new/updated coefficients, the output signal of the high power amplifier 106 is sent to the digital pre-distortion module 206 of the baseband module 102 through a feedback loop that includes the directional coupler 108 and the RF down converter 111. The RF down converter down converts the RF analog signal from the output of the high power amplifier 106 to a baseband or intermediate frequency. In exemplary embodiments, the RF down converter 111 includes an analog-to-digital converter (ADC) to convert the analog signal from the high power amplifier 106 to a digital signal. In other exemplary embodiments, the ADC is included in the baseband module 102. The digital pre-distortion module 206 calculates feedback data based on the output signal of the high power amplifier 106. In exemplary embodiments, feedback data includes an error signal representing the difference between the output signal of the high power amplifier 106 and the modulated signal. The digital pre-distortion module 206 then calculates new/updated coefficients based on the feedback data and the coefficients are applied to the mathematical function.

By including the digital pre-distortion module 206, the high power amplifier 106 can be operated closer to its saturation level over a range of amplitudes. Power amplifiers introduce distortion into the signal, particularly when operating close to the saturation level. However, this distortion is corrected using digital pre-distortion so stringent spectral emissions mask requirements can be met. This technique does not provide a benefit to all applications where a power amplifier is used. Specifically, digital pre-distortion does not provide a benefit to systems where the power requirements of the system are less than that which are required to implement digital pre-distortion. In the embodiments described herein, the power consumption of the radio system exceeds the amount required to implement digital pre-distortion so a benefit is provided.

A second communication path from the baseband module 102 is utilized to vary the drain supply voltage delivered to the high power amplifier 106. By varying the drain supply voltage, the high power amplifier 106 of radio system 100 is operated closer to its saturation level over the entire range of amplitudes, which increases the efficiency of the radio system 100. The DC-DC converter controller 202 of the baseband module 102 generates and sends a signal along the second communication path to the DAC 112. In exemplary embodiments, the DC-DC converter controller 202 sends a signal to the DAC 112 when there is a change in the number of carriers or in the modulation scheme of the carriers for the radio system 100. The DC-DC converter controller 202 detects when there is a change in the number of carriers or the modulation scheme. When there is a change in the number of carriers or the modulation scheme, the DC-DC converter controller 202 measures the amplitude of the waveform supplied by the multi-carrier waveform generator 101. The amplitude of the waveform is proportional to the number of carriers and the PAPR of the carriers. Based on the measured amplitude of the signal, the DC-DC converter controller 202 determines a required signal level to be sent to the DAC 112, such that a particular drain supply voltage will be delivered from the DC-to-DC converter 114 to the high power amplifier 106.The drain supply voltage required for the high power amplifier is proportional to the amount of carriers of a waveform and peak to average power ratio (PAPR) requirements for the carriers. Thus, when the amount of carriers using the radio system 100 or the PAPR requirements of the carriers decreases, the drain supply voltage required for the high power amplifier decreases.

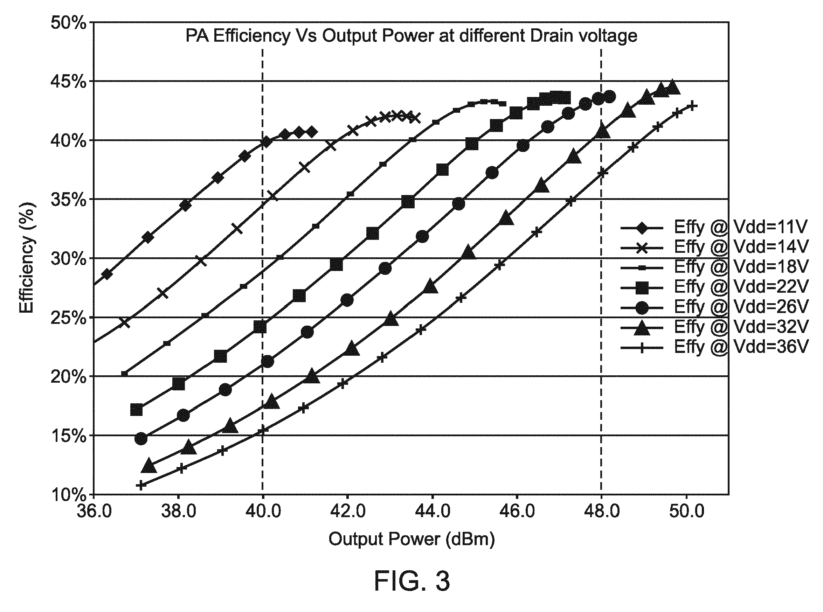

In some exemplary embodiments, the DC-DC converter controller 202 determines the required signal level to be sent to the DAC 112using a look-up table. In some such exemplary embodiments, a look-up tableis created by calibrating the system for maximum efficiency for different combinations of number of carriers and modulation schemes. The different combinations correspond to different levels of output power for the high power amplifier 106. The look-up tablecan be created from data similar to that shown in exemplary Figure 3. It is to be understood that the values in Figure 3 are presented by way of example only and not by way of limitation. For example, for an output power of 40dBm (10W), the highest efficiency is attained using a drain supply voltage of 11V. The required signal level from the DC-DC converter controller 202 can be adjusted depending on the characteristics of the DAC 112 and the DC-to-DC converter 114. In some exemplary embodiments, the look-up table contains the required signal levels to be sent to the DAC 112 for all permutations of the number of carriers and PAPR of the carriers for the radio system 100.

In other exemplary embodiments, alook-up table is not used and the DC-DC converter controller 202 calculates the required signal level to be sent to the DAC 112 using an equation. The equation is derived to fit experimental data for a particular high power amplifier. The experimental data would be obtained in a manner similar to that discussed with reference to the look-up table. Exemplary experimental data is shown in Figure 3. The input variables for the equation would be the number of carriers and the PAPR.

The DAC 112receives the required signal level from the DC-DC converter controller 202 and generates the required analog reference voltage based on the signal sent by the baseband module 102. The DAC 112 sends the analog reference voltage to the DC-to-DC converter 114. In an example, the DAC 112 is a low speed DAC.

The DC-to-DC converter 114 receives the analog reference voltage from the DAC 112. In some exemplary embodiments, the DC-to-DC converter 114 is a non-inverting buck-boost converter. The DC-to-DC converter 114also receives aninput voltage (V_{DC}) from an external source. In some exemplary embodiments, the input voltage is provided by a battery. In other exemplary embodiments, the input voltage is provided by a converter configured to convert the 115 volt AC power from an aircraft into DC power. The DC-to-DC converter 114is configured to output a drain supply voltage to the high power amplifier 106based on the analog reference voltage supplied by the DAC 112. The analog reference voltage corresponds to a particular amount of carriers and modulation scheme. In some exemplary embodiments, the drain supply voltage is greater than the input voltage from the external source that is received by the DC-to-DC converter 114. In other exemplary embodiments, the drain supply voltage is less than the input voltage from the external source that is received by the DC-to-DC converter 114.

As discussed above, the particular drain supply voltage is selected so the high power amplifier 106 operates close to it saturation level over the entire range of amplitudes and is more efficient. This is particularly true for low power output by the high power amplifier 106. Traditional fixed supply voltage power amplifiers are inefficient for low power output because so much of the supplied power is not used. However, for system 100, the drain supply voltage to the high power amplifier 106 is variable and adjusted to optimize efficiency of the power amplifier 106 for any power output.

Additional parts of the radio system 100 can also impact efficiency (e.g.,DC-to-DC converter). The amount of power lost at the DC-to-DC converter 114is equal to the sum of the power loss due to switching and the power loss due to conduction. Power loss due to switching is proportional to the switching frequency and independent of the load current. Power loss due to conduction is proportional to the load current. If the drain supply voltage isupdated at a high frequency, then the power loss due to switching is increased. For a system that is based on envelope tracking, the drain supply voltage is updated at a very high rate. However, for a system that switcheswhen there is a change in the number of carriers or the modulation scheme, such as radio system 100, the drain supply voltage is updated at a much slower rate. This slower switching improves the efficiency of DC-to-DC converter 114 and the radio system 100.

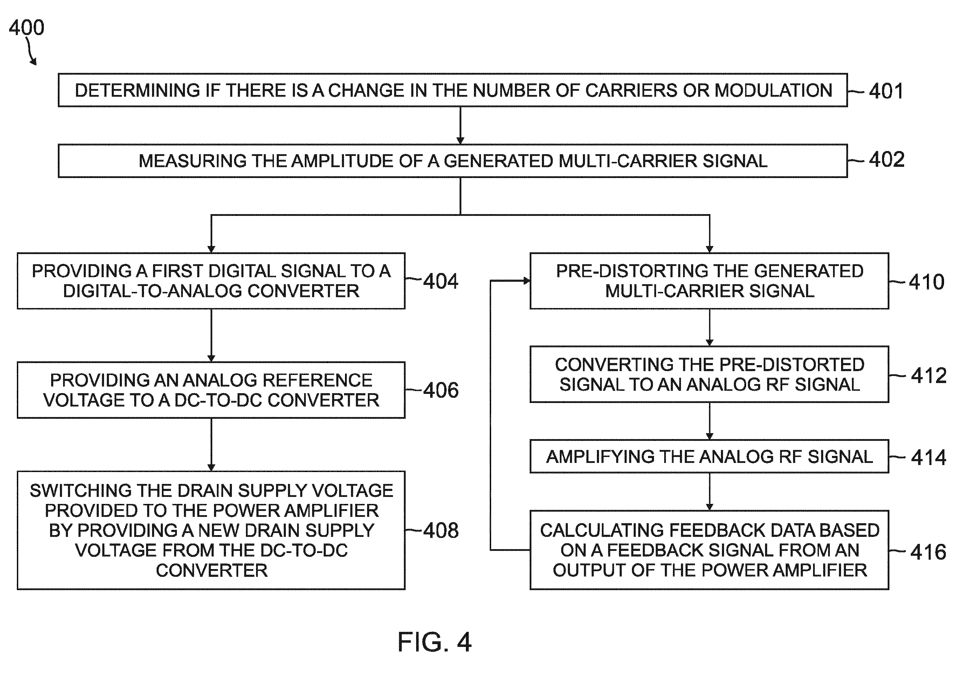

Figure 4 is a flow chart depicting one embodiment of an exemplary method 400 for improving the efficiency of a radio system. Method 400 can be implemented in the radio system 100 described above. It is to be understood that although method 400 is discussed in a serial fashion, individual acts can be performed in different order or in parallel with other acts.

At block 401, it is determined whether there has been a change in the number of carriers or the modulation scheme of the carriers. At block 402, the amplitude of a generated multi-carrier signal is measured. The amplitude of the generatedmulti-carrier signal is proportional to the number of carriers and the modulation scheme of those carriers. In some exemplary embodiments, the baseband module measures the amplitude of the generated multi-carrier signal when there is a change in either the number of carriers or the modulation scheme of the carriers.

At block 404, a first digital signal is output or provided by the baseband module to a digital-to-analog converter (DAC). The first digital signal corresponds to the measured amplitude of the generated signal. Thefirst digital signal also corresponds to a desired drain supply voltage that is to be delivered to a high power amplifier. In some exemplary embodiments, the first digital signal is determined using a look-up table. In other exemplary embodiments, the first digital signal is determined using an equation. The first digital signal is output or provided by the baseband module when there is a change in either the number of carriers or the modulation scheme of the carriers. In exemplary embodiments, the first digital signal is selected to maximize the efficiency of the high power amplifier.

At block 406, the first digital signal is converted to an analog reference voltage signal by a digital to analog converter (DAC) and output to a DC-to-DC converter. The analog reference voltage corresponds to the first digital signal and the drain supply voltage to be delivered to the high power amplifier.

At block 408, a drain supply voltage is output or provided by the DC-to-DC converter to a high power amplifier based on the analog reference voltage signal received from the DAC. The drain supply voltage provided by the DC-to-DC converter is variable and depends on the number of carriers and the modulation scheme of the carriers as indicated by the analog reference voltage signal.

At block 410, the baseband module pre-distorts the generated multi-carrier signal for transmission over an antenna. In exemplary embodiments, the generated multi-carrier signal is a digital signal and is pre-distorted based on coefficients calculated in the baseband module.

At block 412, the generated multi-carrier signal is converted to an analog signal. In exemplary embodiments, the analog signal can also be up-converted from a baseband or intermediate frequency to a radio frequency prior to amplification.

At block 414, the analog signal is amplified by the high power amplifier. In exemplary embodiments, the high power amplifier is operating close to its saturation level. Thus, amplifying the analog signal introduces distortion into the amplified analog signal. In exemplary embodiments, the distortion from the high power amplifier is cancelled by the pre-distortion performed in the baseband module.

At block 416, feedback data is calculated in the baseband module based on a feedback signal that is the output of the high power amplifier. In exemplary embodiments, the feedback signal includes samples of the output of the high power amplifier. In some exemplary embodiments, the output of the high power amplifier is down-converted and converted to a third digital signal. The third digital signal corresponding to the feedback data is compared to the second digital signal to determine a difference or error between the two digital signals. In exemplary embodiments, the baseband module calculates new coefficients for the pre-distortion when differences or errors are found between the second and third digital signals.

The above systems and methods utilize a variable drain supply voltage and digital pre-distortion to produce a more efficient radio system. The above systems and methods are particularly advantageous for increasing the efficiency of the radio system for low output power requirements when compared to traditional implementations. The high power amplifier is more efficient because it is operating closer to its saturation level over the range of amplitudes. The normal distortion caused by a high power amplifier operating near its saturation level is compensated by using digital pre-distortion. The use of digital pre-distortion enables the radio system to meet stringent spectral emissions mask requirements while increasing the efficiency of the high power amplifier.

The slow rate of switching in the above systems and methods also provides a greater level of efficiency. Systems that constantly track the amplitude of the generated signal switch at a very high rate of speed cause inefficiencies through heat loss. The above systems and methods switch the drain supply voltage when there is a change in the number of carriers or the modulation of the carriers. This results in a much slower rate of switching and reduces the inefficiency of the DAC and the DC-to-DC converter.

### Example Embodiments

Example 1 includes a radio system, comprising: an antenna; a baseband module, wherein the baseband module is configured to output a first signal to the antenna, wherein the baseband module is configured to pre-distort the first signal based on computed coefficients, wherein the baseband module is configured to output a second signal, wherein the second signal is determined based on one or more characteristics of the first signal, wherein the second signal is output if there is a change in the one or more characteristics of the first signal; a power amplifier communicatively coupled to the baseband module and the antenna, wherein the power amplifier is configured to amplify the pre-distorted signal; and a variable power supply communicatively coupled to the power amplifier and the baseband module, wherein the variable power supply is configured to receive the second signal and generate a variable drain supply voltage corresponding to the second signal, wherein the drain supply voltage is output to the power amplifier, wherein the variable power supply includes a DC-to-DC converter.

Example 2 includes the circuit of Example 1, wherein the one or more characteristics of the first signal includes the number of carriers.

Example 3 includes the circuit of any of Examples 1-2, wherein the one or more characteristics of the system further includes a modulation scheme of the carriers.

Example 4 includes the system of any of Examples 1-3, wherein the second signal is determined using a look-up table, wherein the look-up table includes information regarding the one or more characteristics of the first signal and a signal level for the second signal corresponding to the one or more characteristics of the first signal.

Example 5 includes the system of any of Examples 1-4, wherein the second signal is calculated based on the one or more characteristics of the first signal.

Example 6 includes the system of any of Examples 1-5, wherein the drain supply voltage output corresponds to a value such that the power amplifier is operated near the saturation level of the power amplifier over a range of amplitudes of the first signal.

Example 7 includes the system of any of Examples 1-6, wherein the DC-to-DC converter is a non-inverting buck boost converter.

Example 8 includes the system of any of Examples 1-7, wherein the baseband module is configured to receive a feedback signal from the power amplifier, wherein the feedback signal is a sample of the output of the power amplifier, wherein the baseband module is configured to calculate updated computed coefficients based on the feedback signal.

Example 9 includes the system of Example 8, further comprising: an up-converter configured to convert the pre-distorted first signal output by the baseband module from a baseband or intermediate frequency to a radio frequency; and a down-converter configured to convert the feedback signal from the power amplifier from a radio frequency to a baseband or intermediate frequency.

Example 10 includes the system of any of Examples 1-9, wherein the radio system comprises one of a satellite communication radio, a very high frequency radio, or an ultra-high frequency radio.

Example 11 includes a method of improving the efficiency of a radio system, comprising: pre-distorting a first digital signal based on computed coefficients, wherein an amplitude of the first digital signal corresponds to one or more characteristics of the first digital signal; converting the pre-distorted first digital signal to a pre-distorted first analog signal; measuring the amplitude of the first digital signal; generating a second digital signal if there is a change in the one or more characteristics of the first digital signal; converting the second digital signal to a second analog signal; switching a drain supply voltage provided to a power amplifier based on the second analog signal; amplifying the pre-distorted first analog signal with the power amplifier.

Example 12 includes the method of Example 11, further comprising calculating feedback data based on a feedback signal containing samples of the output of the power amplifier.

Example 13 includes the method of Example 12, further comprising re-calculating the computed coefficients based on the feedback data.

Example 14 includes the method of any of Examples 11-13, wherein generating the second digital signal includes using a look-up table, wherein the look-up table includes information regarding the one or more characteristics of the first digital signal and a signal level for the second digital signal corresponding to the one or more characteristics of the first digital signal.

Example 15 includes the method of any of Examples 11-14, wherein generating the second digital signal includes calculating a signal level of the second digital signal based on the one or more characteristics of the first digital signal.

Example 16 includes a program product comprising a non-transitory processor-readable medium on which program instructions are embodied, wherein the program instructions are configured, when executed by at least one programmable processor, to cause the at least one programmable processor to: receive data from a plurality of carriers; modulate a first digital data signal; pre-distort the modulated first digital data signal based on computed coefficients; and output the first digital data signal to a power amplifier; and measure an amplitude of the first digital data signal; determine a number of carriers and a modulation of the carriers associated with the first digital data signal; and generate a second digital data signal based on the number of carriers and the modulation of the carriers, wherein the second digital data signal is generated when there is a change in the number of carriers or the modulation of the carriers; and output the second digital data signal to the power amplifier through a digital-to-analog converter and a DC-to-DC converter.

Example 17 includes the non-transitory computer readable medium of Example 16, wherein the program instructions are further configured to cause the at least one programmable processor to: receive a feedback signal containing samples of the output of a power amplifier; and re-calculate the computed coefficients based on the feedback signal.

Example 18 includes the non-transitory computer readable medium of any of Examples 16-17, wherein the program instructions are further configured to cause the at least one programmable processor to generate the second digital data signal using a look-up table, wherein the look-up table includes information regarding the number of carriers, the modulation of the carriers, and a signal level for the second digital signal corresponding to the number of carriers and the modulation of the carriers.

Example 19 includes the non-transitory computer readable medium of any of Examples 16-18, wherein the program instructions are further configured to cause the at least one programmable processor to calculate the second digital data signal based on the number of carriers and the modulation of the carriers.

Example 20 includes the non-transitory computer readable medium of any of Examples 16-19, wherein the generated second digital data signal corresponds to a drain supply voltage of the power amplifier that operates the power amplifier near its saturation level over a range of amplitudes of the modulated first digital signal.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A radio system (100), comprising:
an antenna (110);
a baseband module (102), wherein the baseband module (102) is configured to output a first signal to the antenna (110), wherein the baseband module (102) is configured to pre-distort the first signal based on computed coefficients, wherein the baseband module (102) is configured to output a second signal, wherein the second signal is determined based on one or more characteristics of the first signal, wherein the second signal is output if there is a change in the one or more characteristics of the first signal;
a power amplifier (106) communicatively coupled to the baseband module (102) and the antenna (110), wherein the power amplifier (106) is configured to amplify the pre-distorted signal; and
a variable power supply communicatively coupled to the power amplifier (106) and the baseband module (102), wherein the variable power supply is configured to receive the second signal and generate a variable drain supply voltage corresponding to the second signal, wherein the drain supply voltage is output to the power amplifier (106), wherein the variable power supply includes a DC-to-DC converter (114).

2. The system (100) of claim 1, wherein the one or more characteristics of the first signal includes the number of carriers.

3. The system (100) of claim 1, wherein the one or more characteristics of the system (100) further includes a modulation scheme of the carriers.

4. The system (100) of claim 1, wherein the second signal is determined using a look-up table, wherein the look-up table includes information regarding the one or more characteristics of the first signal and a signal level for the second signal corresponding to the one or more characteristics of the first signal.

5. The system (100) of claim 1, wherein the second signal is calculated based on the one or more characteristics of the first signal.

6. The system (100) of claim 1, wherein the drain supply voltage output corresponds to a value such that the power amplifier (106) is operated near the saturation level of the power amplifier (106) over a range of amplitudes of the first signal.

7. The system (100) of claim 1, wherein the baseband module (102) is configured to receive a feedback signal from the power amplifier (106), wherein the feedback signal is a sample of the output of the power amplifier (106), wherein the baseband module (102) is configured to calculate updated computed coefficients based on the feedback signal.

8. A method of improving the efficiency of a radio system (100), comprising:
pre-distorting a first digital signal based on computed coefficients, wherein an amplitude of the first digital signal corresponds to one or more characteristics of the first digital signal (410);
converting the pre-distorted first digital signal to a pre-distorted first analog signal (412);
measuring the amplitude of the first digital signal (402);
generating a second digital signal if there is a change in the one or more characteristics of the first digital signal;
converting the second digital signal to a second analog signal;
switching a drain supply voltage provided to a power amplifier (106) based on the second analog signal (408);
amplifying the pre-distorted first analog signal with the power amplifier (106) (414).

9. The method of claim 8, further comprising calculating feedback data based on a feedback signal containing samples of the output of the power amplifier (106) (416).

10. The method of claim 9, further comprising re-calculating the computed coefficients based on the feedback data.
